Europäisches Patentamt

European Patent Office

Office européen des brevets

(19)

(11) **EP 0 836 080 B2**

(12) # NEUE EUROPÄISCHE PATENTSCHRIFT

(45) Veröffentlichungstag und Bekanntmachung des Hinweises auf die Entscheidung über den Einspruch:
**16.03.2005 Patentblatt 2005/11**

(45) Hinweis auf die Patenterteilung:
**11.09.2002 Patentblatt 2002/37**

(21) Anmeldenummer: **97117015.4**

(22) Anmeldetag: **01.10.1997**

(51) Int Cl.[7]: **G01D 18/00**, G01R 35/02

(54) **Kontrollvorrichtung und Verfahren zur Prüfung von positionsabhängigen Abtastsignalen**

Device and process for testing position-dependent signals

Dispositif et procédé pour contrôler les signaux dépendants de la position

(84) Benannte Vertragsstaaten:
**DE FR GB IT**

(30) Priorität: **12.10.1996 DE 19642199**

(43) Veröffentlichungstag der Anmeldung:
**15.04.1998 Patentblatt 1998/16**

(73) Patentinhaber: **Dr. Johannes Heidenhain GmbH 83292 Traunreut (DE)**

(72) Erfinder:
• **Holzapfel, Wolfgang, Dr.
83119 Obing (DE)**
• **Huber, Alois, Dipl-Ing.
83365 Nussdorf (DE)**
• **Bernhard, Robert, Dipl.-Ing.
84518 Garching/Alz (DE)**

(56) Entgegenhaltungen:
EP-B- 0 514 081         DE-A- 4 336 767
DE-A- 19 642 200       JP-A- 8 029 197

• **PATENT ABSTRACTS OF JAPAN vol. 014, no. 191 (P-1038), 18.April 1990 & JP 02 036313 A (FANUC LTD), 6.Februar 1990,**
• **RG2 Linear Encoder Installation Instructions ausgegeben von Renishaw Transducer Systems Ltd, Part No. H-9000-4002-PB-A**
• **Extract from DSP56000 24-bit Digital Signal Processor Family Manual,Motorola Inc., front page, Section 1 (p. 1-1 to p.1-12) and last page, 1994**

EP 0 836 080 B2

**Beschreibung**

Die Erfindung betrifft eine Kontrollvorrichtung und ein Verfahren zur Prüfung von positionsabhängigen Abtastsignalen einer Positionsmeßeinrichtung.

Die Prüfung der Abtastsignale ist insbesondere bei der Montage einer Positionsmeßeinrichtung erforderlich. Die Signalqualität und Meßgenauigkeit ist erheblich von der exakten Justierung des Abtastkopfes relativ zum Maßstab abhängig. Um bei inkrementalen Positionsmeßsystemen eine hohe Meßgenauigkeit zu gewährleisten, sollen die beiden vom Abtastkopf erzeugten Abtastsignale eine hohe und gleiche Amplitude sowie einen gegenseitigen Phasenversatz $\phi$ von 90° aufweisen. Die Amplitude wird vom Abstand zwischen Abtastkopf und Maßstab und der Phasenversatz von der Verkippung des Abtastkopfes relativ zur Meßrichtung beeinflußt.

Diese Parameter der analogen Abtastsignale können mit einem Oszilloskop sehr gut dargestellt werden. Hierzu werden die beiden um 90° gegeneinander phasenverschobenen Abtastsignale den beiden Kanälen eines Zweistrahl-Oszilloskops zugeführt, so daß am Bildschirm eine Lissajous-Figur erzeugt wird. Der Radius der Lissajous-Figur ist ein Maß für die Amplituden sowie die Phasenbeziehung beider Abtastsignale.

Um die Prüfung von positionsabhängigen Abtastsignalen zu vereinfachen, wurde in der WO 90/02956 eine Kontrollvorrichtung mit einer Balkenanzeige vorgeschlagen. In dieser Kontrollvorrichtung - von der unsere Erfindung ausgeht - wird aus den momentanen Amplituden der Abtastsignale ein Radius der Lissajous-Figur errechnet und dieser momentane Radiuswert als leuchtende Stelle auf einer Balkenanzeige dargestellt.

Diese Kontrollvorrichtu ng ist gegenüber einem Oszilloskop zwar leichter handzuhaben, eine exakte Kontrolle der Parameter der Abtastsignale ist aber nicht möglich.

Bei der Montage des Abtastkopfes relativ zum Maßstab kann die Amplitude der Abtastsignale Werte von Null bis zu einem Maximum erreichen, beispielsweise 0μA bis 12μA. Dieser relativ große Bereich von 12μA muß zur Prüfung der Abtastsignale kontrolliert und somit angezeigt werden können. Das bedeutet zwangsläufig, daß die Auflösung der Anzeige bei einer noch gut handhabbaren und nicht zu langen Balkenanzeige sehr gering ist. Diese geringe Auflösung hat den Nachteil, daß die Schwankungsbreite des Radius der Lissajous-Figur nicht mit ausreichender Auflösung und Genauigkeit dargestellt werden kann, wenn jeweils nur der momentane Radiuswert als leuchtender Punkt erscheint.

DerErfindungliegtdieAufgabezugrunde,eine Kontrollvorrichtung und ein Verfahren zur Prüfung von positionsabhängigen Abtastsignalen anzugeben, mit der/dem Parameter der Abtastsignale mit ausreichend hoher Auflösung und Genauigkeit angezeigt werden können.

Diese Aufgabe wird durch eine Kontrollvorrichtung mit den Merkmalen der Ansprüche 1 und 14 sowie einem Verfahren mit den Merkmalen des Anspruches 17 gelöst.

Vorteilhafte Ausgestaltungen sind in den abhängigen Ansprüchen angegeben.

Die Vorteile der erfindungsgemäßen Kontrollvorrichtung sind besonders darin zu sehen, daß besonders wichtige Parameter der Abtastsignale besser erkannt werden können und dadurch eine gute Qualität der Abtastsignale mit einfachen Mitteln erreicht werden kann.

Ausführungsbeispiele der Erfindung sind in den Figuren dargestellt, es zeigt:

Figur 1 ein Positionsmeßsystem mit einer erfindungsgemäßen Kontrollvorrichtung,

Figur 2 die Kontrollvorrichtung mit einem digitalen Abtastkopf des Positionsmeßsystems,

Figur 3 eine Lissajous-Figur,

Figur 4 ein erstes Beispiel des Anzeigefeldes der Kontrollvorrichtung,

Figur 5 ein zweites Beispiel des Anzeigefeldes der Kontrollvorrichtung,

Figur 6 und 7 zwei Zustände eines dritten Beispiels des Anzeigefeldes der Kontrollvorrichtung.

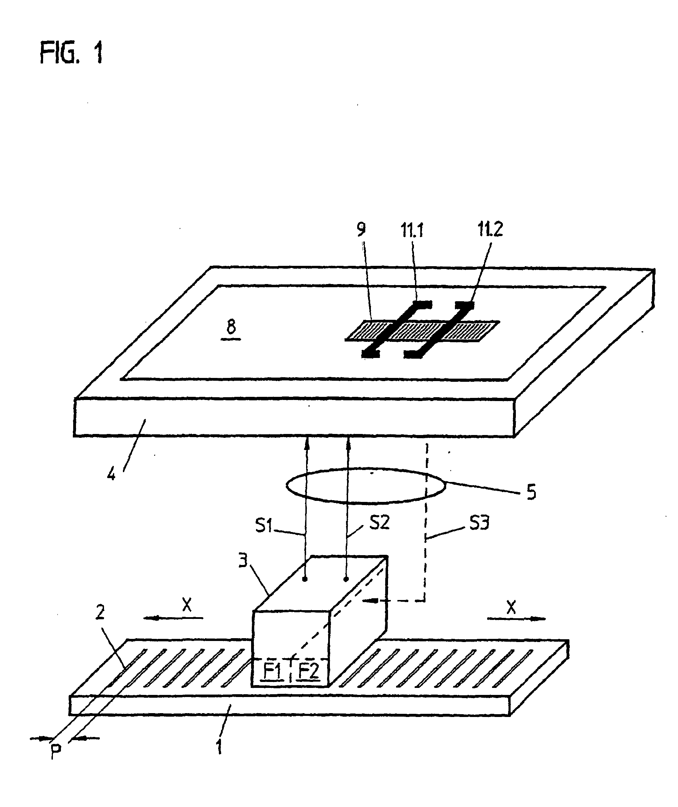

Ein Maßstab 1 mit einer inkrementalen Teilung 2 wird gemäß Figur 1 von einem Abtastkopf 3 abgetastet. Während des Meßbetriebes sollen die Abtastelemente F1, F2 - beispielsweise Fotoelemente - des Abtastkopfes 3 zwei um $\phi = 90°$ gegeneinander phasenverschobene analoge Abtastsignale S1, S2 ausgeben. Diese Abtastsignale S1, S2 werden in einer Unterteilungseinheit interpoliert, um einen Positionsmeßwert zu erhalten, dessen Auflösung besser ist als eine Teilungsperiode P der inkrementalen Teilung 2. Um eine Interpolation mit hoher Genauigkeit zu gewährleisten, ist es erforderlich, daß die analogen Abtastsignale S1, S2 exakt um die Soll-Phasenlage $\phi = 90°$ gegeneinander phasenverschoben sind, eine möglichst hohe Signalamplitude A aufweisen und die Signalamplituden A1, A2 beider Abtastsignale S1=A1*sin ωt und S2=A2*cos ωt möglichst gleich sind. Erfindungsgemäßwerden deshalb die analogen Abtastsignale S1, S2 einer Kontrollvorrichtung 4 zugeführt, mit der diese Parameter (Phasenlage, Amplitude) besonders effektiv überprüft werden können.

Zur Abtastung eines Maßstabes 1 sind sogenannte analoge und digitale Abtastköpfe 3 bekannt. Ein analoger Abtastkopf 3 liefert im Meßbetrieb über seine Ausgangsleitung 5 die analogen Abtastsignale S1, S2 an eine Folgeelektronik - beispielsweise an einen Zähler oder eine numerische Steuerung - in der die Unterteilung und Positionsmeßwertbildung erfolgt. Ein derartiger Abtastkopf 3 ist in Figur 1 dargestellt.

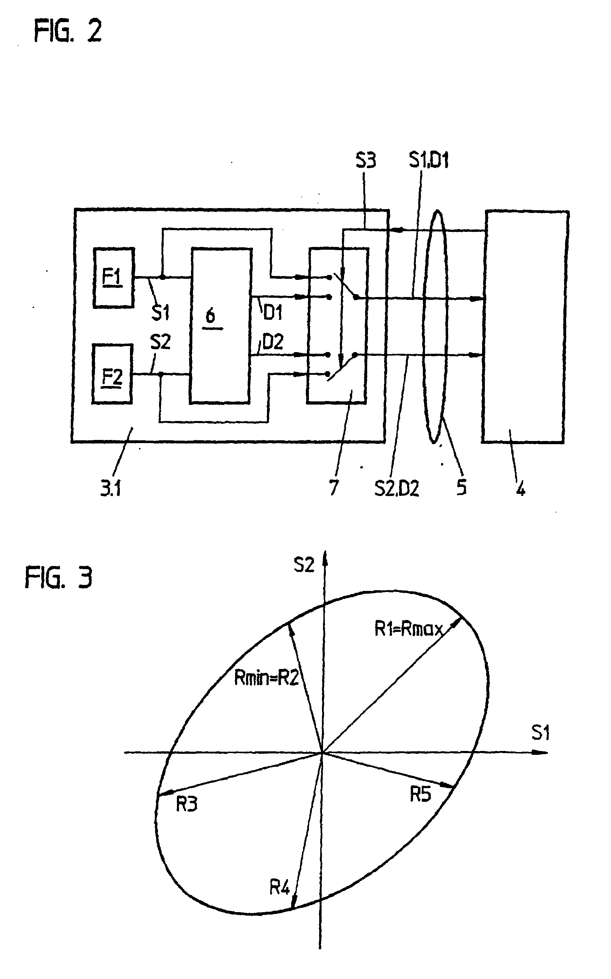

Ein digitaler Abtastkopf 3.1 ist so ausgeführt, daß über seine Ausgangsleitung 5 bereits digitale Signale an eine Folgeelektronik weitergeleitet werden. Hierzu ist im Abtastkopf 3.1 die Unterteilungseinheit 6 integriert. Mit der erfindungsgemäßen Kontrollvorrichtung 4 soll es möglich sein, auch bei einem digitalen Abtastkopf 3.1 die analogen Abtastsignale S1, S2 der Abtastelemente F1, F2 zu prüfen. Hierzu wird von der Kontrollvorrichtung 4 ein Steuersignal S3 zu dem digitalen Abtastkopf 3.1 geführt, das eine Um-schalteinrichtung 7 im Abtastkopf 3.1 aktiviert, um anstelle der digitalen Ab-tastsignale D1, D2 die analogen Abtastsignale S1, S2 zur Kontrollvorrich-tung 4 zu übertragen. Ein derartiger digitaler Abtastkopf 3.1 ist in Figur 2 schematisch dargestellt. Zur Automatisierung der Umschaltung steht an ei-nem Steckerkontakt der Kontrollvorrichtung 4 immer das Steuersignal S3 an. Sobald eine elektrische Verbindung zwischen dem digitalen Abtastkopf 3.1 und der Kontrollvorrichtung 4 erfolgt, veranlaßt das anstehende Steuer-signal S3 sofort eine Umschaltung des Abtastkopfes 3.1 vom digitalen auf analogen Signalausgang D1, D2 → S1, S2.

Zur Darstellung der Parameter der beiden Abtastsignale S1, S2 ist in der Kontrolivorrichtung 4 ein Anzeigefeld 8 vorgesehen. Angezeigt wird der Radius R einer in Figur 2 gezeigten Lissajous-Figur. Hierzu werden laufend nacheinander mehrere Wertepaare (Signalamplituden) beider Abtastsignale S1, S2 übernommen und aus jedem Wertepaar jeweils der momentane Radius R1 bis R5 der Lissajous-Figur nach folgender Beziehung errechnet:

$$R= \sqrt{S1^2 + S2^2}$$

Aus einer bestimmten Anzahl von aufeinanderfolgend berechneten und abgespeicherten Radius-Werten R1 bis R5 wird jeweils der minimale $R_{min}$ und der maximale Wert $R_{max}$ ermittelt und auf dem Anzeigefeld 8 ein kontinuierlicher Balken 9 zwischen diesen beiden Extemwerten $R_{max}$ und $R_{min}$ angezeigt. Besonders vorteilhaft dabei ist, wenn sichergestellt ist, daß bei der Gruppe der errechneten Radius-Werte R1 bis R5 aus der jeweils $R_{max}$ und $R_{min}$ bestimmt wird, zumindest jeweils ein Radius-Wert R innerhalb eines der vier Quadranten der Lissajous-Figur liegt. Um dies zu überwachen, können die Radius-Werte einer Prüfung unterzogen werden, wobei $R_{max}$ und $R_{min}$ erst errechnet wird, wenn zumindest je ein Wert innerhalb eines Quadranten liegt.

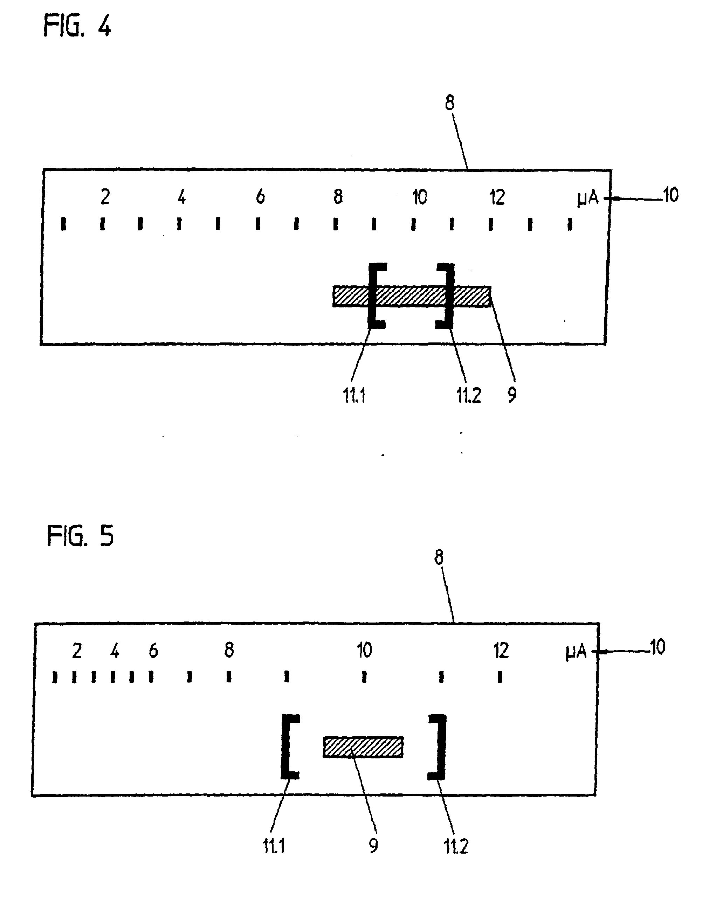

Ein erstes Beispiel der Anzeige eines derartigen Balkens 9 ist in Figur 4 dargestellt. Bei einer Relatiwerschiebung des Abtastkopfes 3 relativ zum Maßstab 1 in Meßrichtung X wurden in einem vorgegebenen Zeitraster mehrere Meßwerte für den Radius R ermittelt, die Kontrollvorrichtung 4 ermittelt aus diesen Meßwerten den Minimalwert $R_{min}$=8µA und den Maximalwert $R_{max}$=12µA. Daraufhin wird ein durchgehender Balken 9 von 8 bis 12µA im Anzeigefeld 8 angezeigt. Ändert sich $R_{min}$ und $R_{max}$ bei den nachfolgenden Messungen und Berechnungen neuer Radius-Werte R, so ändert sich auch der Bereich des Balkens 9.

Im Anzeigefeld 8 wird bei dem dargestellten Beispiel auch ein Maß 10 für den Radius R angezeigt, im Beispiel 1 bis 14µA.

Besonders vorteilhaft ist es, wenn im Anzeigefeld 8 weiterhin eine Markierung 11 für die Sollbreite des Balkens 9, also für die zulässige Toleranz der Schwankungsbreite des Radius R erscheint. Im dargestellten Beispiel ist dies eine Klammer 11.1 und 11.2. Ist beispielsweise die zulässige Toleranz ±10%, so wird die linke, dem Balken 9 überlagerte Klammer 11.1 bei 9µA, und die rechte, dem Balken 9 überlagerte Klammer 11.2 bei 11µA angezeigt. Anstelle der Klammern 11.1 und 11.2 können auch andere Markierungen dargestelltwerden. Die Lage der Klammern 11.1, 11.2 errechnet sich nach folgendem Schema:

a) Berechnen eines Mittelwertes RM aus mehreren aufeinanderfolgenden Radius-Werten R. Der Mittelwert RM kann der arithmetische Mittelwert aus mehreren Radius-Werten R sein, oder der Wert $(R_{max}+R_{min})/2$.

b) Berechnen der Lage der linken Klammer 11.1, indem (RM-10% von RM) errechnet wird. Im Beispiel ist RM=10µA und somit die zulässige Schwankungsbreite des Radius R=±1µA, so daß die linke Klammer 11.1 bei 9µA dargestellt wird.

c) Berechnen der Lage der rechten Klammer 11.2, indem (RM+10% von RM) errechnet wird. Im Beispiel ergibt sich dafür 11µA.

Da die zulässig Toleranz in %, das heißt relativ vorgegeben ist, ändert sich der eingeschlossene Bereich zwischen rechter und linker Klammer 11.1, 11.2 in Abhängigkeit vom momentanen Mittelwert RM.

Bei der Prüfung der Positionsmeßeinrichtung - insbesondere während des Anbaus des Abtastkopfes 3 - wird die Ausgangsleitung 5 des Abtastkopfes 3 mit der Kontrollvorrichtung 4 verbunden. Der Abstand des Abtastkopfes 3 zum Maßstab 1 sowie die winkelmäßige Ausrichtung des Abtastkopfes 3 ist korrekt, wenn der Balken 9 möglichst weit rechts des Anzeigefeldes 8 erscheint und eine Breite aufweist, die innerhalb der Klammern 11.1, 11.2 liegt.

Zusätzlich zu der Markierung 10 kann auch noch eine weitere Markierung für den berechneten Mittelwert RM angezeigt werden. Beispielsweise ein Strich, Punkt oder Pfeil beim Wert 10µA.

In Figur 5 ist ein weiteres Beispiel der Kontrollvorrichtung 4 dargestellt. Innerhalb des Anzeigefeldes 8 wird wiederum ein Maß 10 für den Radius angezeigt. Dieses Maß 10 sind Wertangaben von 0 bis 12μA. Wesentlich bei diesem Beispiel ist die Spreizung des Anzeigebereiches im besonders wichtigen Bereich des Soll-Wertes, also im Bereich von 8 bis 12μA. Diese vergrößerte Darstellung innerhalb eines begrenzten Bereiches erleichtert die Feinjustierung des Abtastkopfes 3. Kleine Abweichungen und Änderungen von der Soll-Lage des Balkens 9 (z.B. bei 10μA) werden schneller erkannt. Insbesondere kann die Schwankungsbreite des Radius - also die Breite des Balkens - besonders deutlich dargestellt werden und dadurch eine sehr gute Amplitudengleichheit der beiden Abtastsignale S1, S2 eingestellt werden.

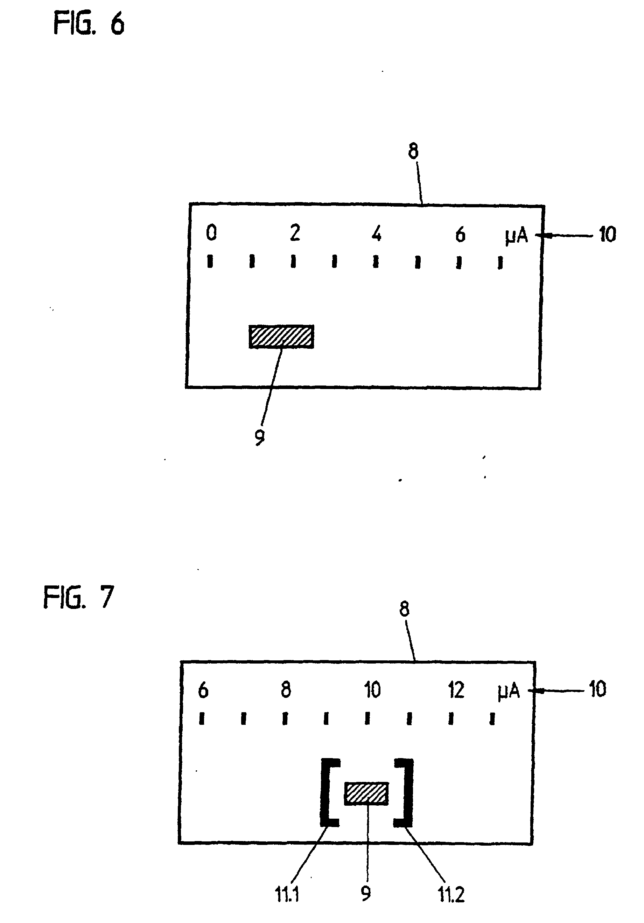

In Figur 6 und 7 ist ein weiteres Beispiel der Erfindung dargestellt. Das Anzeigefeld 8 kann besonders klein ausgebildet werden, wenn in der Kontrollvorrichtung 4 eine Umschalteinrichtung integriert ist, die eine Umschaltung des Anzeigefeldes 8 veranlaßt. Liegt der maximal erfaßte Radius-Wert $R_{max}$ unterhalb eines Grenzwertes von beispielsweise 7μA, wird im Anzeigefeld 8 als Maß 10 ein Wertebereich von 0 bis 7μA angezeigt, sowie der Balken 9 innerhalb der ermittelten Werte $R_{min}$ und $R_{max}$ Wird von der Kontrollvorrichtung 4 erkannt, daß der minimale Radius $R_{min}$ oberhalb eines Grenzwertes von beispielsweise 6μA liegt, so wird innerhalb des gleichen Anzeigefeldes 8 als Maß 10 ein Wertebereich von 6 bis 12μA angezeigt, sowie der Balken 9 und die Klammern 11.1, 11.2, wie bei den vorhergehenden Beispielen erläutert. Wesentlich bei diesem Ausführungsbeispiel ist die Umschaltung der Anzeige in Abhängigkeit der momentanen Lage des Balkens 9. Die Umschaltung kann in Abhängigkeit des erfaßten Momentanwertes von R, in Abhängigkeit von $R_{min}$ bzw. $R_{max}$ mehrerer erfaßter Radius-Werte R oder in Abhängigkeit eines berechneten Mittelwertes RM aus mehreren Radius-Werten erfolgen. Besonders vorteilhaft ist es, wenn im ersten Zustand (Figur 6) von der Anzeige ein unterer Bereich von Radius-Werten angezeigt wird, in dem die Amplituden der Abtastsignale S1, S2 unzureichend sind, und im zweiten Zustand (Figur 7) ein oberer Bereich von Radius-Werten angezeigt wird, in dem die Amplituden der Abtastsignale S1, S2 einen ausreichenden Wert erreicht haben. In diesem zweiten Zustand kann dann in dem Anzeigefeld 8 die Schwankungsbreite des Radius besonders beobachtet und genau eingestellt werden. Aus diesem Grund ist es auch möglich, daß das Maß 10 und somit die sich ändernde Lage und die Schwankungsbreite des Balkens 9 im zweiten Zustand gegenüber dem ersten Zustand vergrößert dargestellt wird.

Bei allen Ausführungsbeispielen ist es weiterhin möglich, daß die Schwankungsbreite - also die Breite des Balkens 9 - gegenüber der Lage vergrößert dargestellt wird. An einem Beispiel erläutert bedeutet dies, daß bei ermittelten Radius-Werten $R_{min}$=9μA und $R_{max}$=11μA der Mittelwert RM=10μA errechnet wird und

die mittlere Lage des Balkens 9 auch bei 10μA dargestellt wird. Die vergrößerte Darstellung der Schwankungsbreite wird realisiert, indem die Breite des Balkens 9 um einen Faktor, beispielsweise 2, breiter dargestellt wird, das linke Ende somit bei RM-2* (RM-$R_{min}$) =8μAund das rechte Ende bei RM+2* ($R_{max}$-RM)=12μA.

Wie anhand der drei Beispiele der Anzeigefelder 8 beschrieben, stellt die Breite des Balkens 9 die Abweichung (Schwankungsbreite) zwischen mehreren Radius-Werten R dar. Diese Abweichung kann die Differenz zwischen $R_{max}$ und $R_{min}$, aber auch beispielsweise die Standardabweichung zwischen mehreren Radius-Werten R sein.

Der Balken 9 kann auch ohne Maßangabe 10 angezeigt werden, so daß der Bediener nur darauf zu achten hat, daß der Balken 9 möglichst weit rechts zu liegen kommt und möglichst schmal ist.

Der Balken 9 kann auch derart angezeigt werden, daß seine Lage in einer Richtung des Anzeigefeldes 8 den mittleren Radius RM angibt und die Breite des Balkens in der dazu senkrechten Richtung des Anzeigefeldes 9 die Schwankungsbreite (Abweichung) des Radius R angibt.

Bei der Montage und Ausrichtung des Abtastkopfes 3 hat sich gezeigt, daß es vorteilhaft ist, wenn während der Grobjustage möglichst schnell der aktuelle Balken 9 angezeigt wird und bei der Feinjustage der Balken 9 möglichst genau angezeigt wird. Aus diesem Grund wird die Schwankungsbreite bei Radius-Werten unterhalb eines vorgegebenen Wertes - z.B. 50% des Soll-Wertes - aus einer geringeren Anzahl (z.B. 5 Werte) von Radius-Werten und oberhalb dieses vorgegebenen Wertes aus einer großen Anzahl (z.B. 20 Werte) von Radius-Werten berechnet.

In den Beispielen wird von Abtastsignalen S1, S2 ausgegangen, die im Sollzustand um φ= 90° gegeneinander phasenverschoben sind. Die zur Zeit eingesetzten Positionsmeßeinrichtungen 1, 3 geben in der Regel derartige analoge Abtastsignale S1, S2 ab. Die Erfindung ist aber auch einsetzbar, wenn der Sollzustand der Phasenverschiebung φ der zu kontrollierenden Abtastsignale S1, S2 von 90° abweicht. Allgemein errechnet sich der momentane Radius R der Lissajous-Figur aus folgender Beziehung:

$$R= \sqrt{S1^2 + S2^2 -2* \ S1* \ S2*\cos\phi}$$

Es sind auch Positionsmeßeinrichtungen 1, 3 auf dem Markt, die drei um jeweils 120° gegeneinander phasenverschobene analoge sinusförmige Abtastsignale S3, S4, S5 ausgeben. Um diese Abtastsignale S3, S4, S5 in üblichen Interpolationseinrichtungen und Zähleinrichtungen verarbeiten zu können, werden diese Abtastsignale S3, S4, S5 vor der Weiterverarbeitung in die um 90° gegeneinander phasenverschobenen Abtastsignale S1, S2 umgewandelt. Diese Abtastsignale S1, S2 können mit der beschriebenen Kontrollvorrichtung 4 kontrolliert werden. Mit der Erfindung ist es aber auch möglich, bereits die um 120° gegeneinander phasenverschobenen Abtastsignale S3, S4, S5 in der oben beschriebenen Weise zu kontrollieren. Der momentane Radius R der Lissajous-Figur errechnet sich dabei aus folgender Beziehung:

$$R= \frac{2}{3}*\sqrt{S3^2 + S4^2 + S5^2 - S3*S4 - S3-S5 - S4*S5}$$

Beliebige Kombinationen der beschriebenen Beispiele sind realisierbar.

Das Anzeigefeld 8 ist bevorzugt eine Flüssigkristall-Anzeig, auch LCD genannt, die Erfindung ist aber auch mit Anzeigefeldern in Form von Fluoreszenzanzeigen, LED-Zeilen oder LED-Matrix realisierbar.

Die Erfindung ist bei Längen- sowie Winkelmeßsystemen einsetzbar. Die Abtastelemente können lichtelektrische Elemente, magnetische, kapazitive oder induktive Elemente sein.

Die Kontrollvorrichtung mit dem Anzeigefeld kann auch integraler Bestandteil des Abtastkopfes 3 selbst sein, so daß der Balken an einer Fläche des Abtastkopfes 3 angezeigt wird.

Im Anzeigefeld können auch bestimmte Bereiche oder Werte farbig unterschiedlich dargestellt werden.

Die Kontrollvorrichtung kann unabhängig von externen Stromversorgungsquellen auch mittels einer integrierten Batterie betrieben werden.

Die Mittel zur Verarbeitung der Abtastsignale S1, S2 sind bevorzugt digitale Rechner (Mikroprozessor).

**Patentansprüche**

1.  Kontrollvorrichtung zur Kontrolle von gegeneinander phasenver-schobenen Abtastsignalen (S1, S2) einer Positionsmeßeinrichtung (1, 3) welche der Kontrollvorrichtung (4) zur Darstellung einer dem Radius (R) entsprechenden Größe einer Lissajous-Figur zugeführt werden, **dadurch gekennzeichnet, daß** in der Kontrollvorrichtung (4) Mittel vorgesehen sind, um aus einer Reihe von errechneten und abgespeicherten Radius-Werten (R1 bis R5) einen Wert ($R_{max}$-$R_{min}$) für die Schwankungsbreite des Radius (R) zu berechnen, und ein Maß für diesen Wert ($R_{max}$-$R_{min}$) in einem Anzeigefeld (8) anzuzeigen.

2.  Kontrollvorrichtung nach Anspruch 1, **dadurch gekennzeichnet, daß** die Radius-Werte( R1 bis R5) aus den momentanen Amplitudenwerten zweier um 90° gegeneinander phasenverschobener sinusförmiger Abtastsignale (S1, S2) errechnet werden, indem jeweils

$$R= \sqrt{S1^2 + S2^2}$$

gebildet wird.

3.  Kontrollvorrichtung nach Anspruch 1, **dadurch gekennzeichnet, daß** der Wert ($R_{max}$-$R_{min}$) der Schwankungsbreite die Differenz zwischen dem maximalen Radius-Wert ($R_{max}$) und dem minimalen Radius-Wert ($R_{min}$) einer Reihe von Radius-Werten (R1 bis R5) ist.

4.  Kontrollvorrichtung nach einem der Ansprüche 1 bis 3, **dadurch gekennzeichnet, daß** die Schwankungsbreite in Form eines Balkens (9) in einem Anzeigefeld (8) der Kontrollvorrichtung (4) angezeigt wird, und die Breite des Balkens (9) ein Maß für die Schwankungsbreite ist.

5.  Kontrollvorrichgung nach Anspruch 4, **dadurch gekennzeichnet, daß** die Lage des Balkens (9) im Anzeigefeld (8) ein Maß für den mittleren Radius der Reihe von Radius-Werten (R1 bis R5) ist.

6.  Kontrollvorrichtung nach Anspruch 5, **dadurch gekennzeichnet, daß** im Anzeigefeld (8) ein Bereich (10) vorgesehen ist, in dem eine Maßangabe für den Radius-Wert angezeigt wird.

7.  Kontrollvorrichtung nach einem der vorhergehenden Ansprüche, **dadurch gekennzeichnet, daß** die Kontrollvorrichtung (4) Mittel enthält, um im Anzeigefeld (8) eine Markierung (11.1,11.2) anzuzeigen, womit die zulässige Schwankungsbreite der Reihe von Radius-Werten (R1 bis R5) angegeben wird.

8.  Kontrollvorrichtung nach Anspruch 7, **dadurch gekennzeichnet, daß** die Markierung (11.1, 11.2) aus einer unteren Markierung (11.1) und einer zweiten oberen Markierung (11.2) besteht, und daß die Kontrollvorrichtung (4) Mittel enthält, um aus der Reihe von Radius-Werten (R1 bis R5) einen mittleren Radius-Wert (RM) zu berechnen, und Mittel enthält, um einen Wert für die zulässige-Schwankungsbreite abzuspeichern, und weiterhin Mittel enthält, um aus dem mittleren Radius-Wert (RM) und dem abgespeicherten Wert die Positionen beider Markierungen (11.1, 11.2) zu berechnen.

9.  Kontrollvorrichtung nach Anspruch 8, **dadurch gekennzeichnet, daß** der abgespeicherte Wert für die zulässige Schwankungsbreite eine relative Größe bezogen auf den mittleren Radius-Wert (RM) ist, so daß der Abstand beider Markierungen (11.1, 11.2) abhängig vom ermittelten mittleren Radius-Wert (RM) angezeigt wird.

**10.** Kontrollvorrichtung nach einem der Ansprüche 5 bis 10, **dadurch gekennzeichnet, daß** eine Umschalteinrichtung vorgesehen ist, welche in Abhängigkeit eines Radius-Wertes ($R_{max}$, $R_{min}$, RM) den angezeigten Radius-Bereich ändert.

**11.** Kontrollvorrichtung nach Anspruch 10, **dadurch gekennzeichnet, daß** die Umschalteinrichtung die Kontrollvorrichtung (4) veranlaßt, entweder die Schwankungsbreite in einem ersten Zustand oder in einem zweiten Zustand im Anzeigefeld (8) anzuzeigen, wobei im ersten Zustand ein Extremwert ($R_{max}$, $R_{min}$) oder der Mittelwert (RM) der Reihe von Radius-Werten (R1 bis R5) unterhalb eines vorgegebenen Wertes und im zweiten Zustand oberhalb eines vorgegebenen Wertes liegt.

**12.** Kontrollvorrichtung nach einem der Ansprüche 4 bis 11, **dadurch gekennzeichnet, daß** die Breite des Balkens (9) für die Schwankungsbreite zumindest im Bereich eines Lage-Sollwertes in einem größeren Maßstab dargestellt wird, als die sich ändernde Lage des Balkens (9) innerhalb des Anzeigefeldes (8).

**13.** Kontrollvorrichtung nach einem der Ansprüche 4 bis 12, **dadurch gekennzeichnet, daß** die Breite des Balkens (9) für die Schwankungsbreite sowie die sich ändernde Lage des Balkens (9) innerhalb des Anzeigefeldes (8) im Bereich eines Lage-Sollwertes in einem größeren Maßstab dargestellt wird, als im übrigen Bereich.

**14.** Kontrollvorrichtung zur Kontrolle von gegeneinander phasenverschobenen Abtastsignalen (S1, S2) einer Positionsmeßeinrichtung (1, 3), welche der Kontrollvorrichtung (4) zur Darstellung einer dem Radius (R) entsprechenden Größe einer Lissajous-Figur zugeführt werden, **dadurch gekennzeichnet, daß** Mittel vorgesehen sind, welche die Kontrollvorrichtung (4) veranlaßt, zusätzlich zu dieser Größe eine Markierung (11.1, 11.2) in einem Anzeigefeld (8) darzustellen, womit eine vorgebene zulässige Schwankungsbreite einer Reihe von aufeinanderfolgenden Radius-Werten (R1 bis R5) angegeben wird.

**15.** Kontrollvorrichtung nach einem der vorhergehenden Ansprüche, **dadurch gekennzeichnet, daß** Mittel zur Erzeugung eines Steuersignales (S3) vorgesehen sind, das einer Umschalteinrichtung (7) eines Abtastkopfes (3.1) der Positionsmeßeinrichtung zugeführt wird, um zu veranlassen, **daß** anstelle digitaler Abtastsignale (D1, D) analoge Abtastsignale (S1, S2) auf die Ausgangsleitungen (5) des Abtastkopfes (3.1) gelegt werden.

**16.** Kontrollvorrichtung nach einem der vorhergehenden Ansprüche, **dadurch gekennzeichnet, daß** das Anzeigefeld eine Flüssigkristall-Anzeige (8) ist.

**17.** Verfahren zur Prüfung von gegeneinander phasenverschobenen Abtastsignalen (S1, S2) einer Positionsmeßeinrichtung (1, 3), welche einer Kontrollvorrichtung (4) zur Darstellung einer dem Radius (R) entsprechenden Größe einer Lissajous-Figur zugeführt werden, **gekennzeichnet durch** folgende Verfahrensschritte:

a) Berechnen einer Reihe von Radius-Werten (R1 bis R5) aus aufeinanderfolgenden Momentanwerten der beiden Abtastsignale (S1, S2);
b) Abspeichern der errechneten Radius-Werte (R1 bis R5);
c) Berechnen der Schwankungsbreite aus einer vorgegebenen Anzahl von abgespeicherten Radius-Werten (R1 bis R5);
d) Aktivieren eines Anzeigefeldes (8), um ein Maß (9) für die Schwankungsbreite anzuzeigen.

**Claims**

**1.** Control device for checking mutually phase-shifted scanning signals (S1, S2) of a position measuring device (1, 3), which signals are supplied to the control device (4) for representing a dimension of a Lissajous figure corresponding to the radius (R), **characterised in that** means are provided in the control device (4) in order to <u>calculate,</u> from a series of calculated <u>and stored</u> radius values (R1 to R5), a value ($R_{max}$ - $R_{min}$) for the variation width of the radius (R) and in order to display a measure for this value ($R_{max}$ - $R_{min}$) in a display field (8).

**2.** Control device according to claim 1, **characterised in that** the radius values (R1 to R5) are calculated from the instantaneous amplitude values of two sinusoidal scanning signals (S1, S2), which are mutually phase-shifted by 90°, by forming $R = \sqrt{S1^2 + S2^2}$ respectively.

**3.** Control device according to claim 1, **characterised in that** the value ($R_{max}$ - $R_{min}$) of the variation width is the difference between the maximum radius value ($R_{max}$) and the minimum radius value ($R_{min}$) of a series of radius values (R1 to R5).

**4.** Control device according to one of the claims 1 to 3, **characterised in that** the variation width is displayed in the form of a bar (9) in a display field (8) of the control device (4), and the width of the bar (9) is a measure for the variation width.

**5.** Control device according to claim 4, **characterised in that** the position of the bar (9) in the display field (8) is a measure for the average radius of the series of radius values (R1 to R5).

**6.** Control device according to claim 5, **characterised in that** a region (10) is provided in the display field (8), in which region a measure parameter for the radius value is displayed.

**7.** Control device according to one of the preceding claims, **characterised in that** the control device (4) contains means in order to display a marking (11.1, 11.2) in the display field (8), with which the permissible variation width of the series of radius values (R1 to R5) is indicated.

**8.** Control device according to claim 7, **characterised in that** the marking (11.1, 11.2) comprises a lower marking (11.1) and a second upper marking (11.2), and **in that** the control device (4) contains means in order to calculate an average radius value (RM) from the series of radius values (R1 to R5), and contains means in order to store a value for the permissible variation width, and furthermore contains means in order to calculate the positions of both markings (11.1, 11.2) from the average radius value (RM) and the stored value.

**9.** Control device according to claim 8, **characterised in that** the stored value for the permissible variation width is a relative dimension with respect to the average radius value (RM), so that the spacing of both markings (11.1, 11.2) is displayed dependent upon the determined average radius value (RM).

**10.** Control device according to one of the claims 5 to 10, **characterised in that** a switching device is provided, which changes the displayed radius range dependent upon a radius value ($R_{max}$, $R_{min}$, RM).

**11.** Control device according to claim 10, **characterised in that** the switching device causes the control device (4) to display the variation width in the display field (8) either in a first state or in a second state, in the first state an extreme value ($R_{max}$, $R_{min}$) or the average value (RM) of the series of radius values (R1 to R5) being below a prescribed value, and in the second state being above a prescribed value.

**12.** Control device according to one of the claims 4 to 11, **characterised in that** the width of the bar (9) for the variation width is represented, at least in the region of a position reference value, on a larger scale than the changing position of the bar (9) within the display field (8).

**13.** Control device according to one of the claims 4 to 12, **characterised in that** the width of the bar (9) for the variation width and the changing position of the bar (9) within the display field (8) is represented, in the region of a position reference value, on a larger scale than in the remaining region.

**14.** Control device for checking mutually phase-shifted scanning signals (S1, S2) of a position measuring device (1, 3), which signals are supplied to the control device (4) for representing a dimension of a Lissajous figure corresponding to the radius (R), **characterised in that** means are provided which cause the control device (4) to represent, additionally to this dimension, a marking (11.1, 11.2) in a display field (8), with which a prescribed permissible variation width of a series of successive radius values (R1 to R5) is indicated.

**15.** Control device according to one of the preceding claims, **characterised in that** means for generating a control signal (S3) are provided, which signal is supplied to a switching device (7) of a scanning head (3.1) of the position measuring device, in order to cause analogue scanning signals (S1, S2), instead of digital scanning signals (D1, D), to be applied to the output lines (5) of the scanning head (3.1).

**16.** Control device according to one of the preceding claims, **characterised in that** the display field is a liquid crystal display (8).

**17.** Method for checking mutually phase-shifted scanning signals (S1, S2) of a position measuring device (1, 3), which signals are supplied to a control device (4) for representing a dimension of a Lissajous figure corresponding to the radius (R), **characterised by** the following method steps:

a) calculation of a series of radius values (R1 to R5) from successive instantaneous values of the two scanning signals (S1, S2);
b) storage of the calculated radius values (R1 to R5);
c) calculation of the variation width from a prescribed number of stored radius values (R1 to R5);
d) activation of a display field (8) in order to display a measure (9) for the variation width.

## Revendications

**1.** Dispositif de contrôle pour le contrôle de signaux de palpage (S1, S2) mutuellement déphasés d'un dispositif de mesure de position (1, 3) qui sont transmis au dispositif de contrôle (4) aux fins de représenter une grandeur d'une figure de Lissajous correspondant au rayon (R), **caractérisé en ce qu'**il est prévu dans le dispositif de contrôle (4) des moyens pour calculer à partir d'une série de valeurs de rayons (R1 à R5) calculées et mémorisées, une valeur ($R_{max}$-$R_{min}$) pour l'amplitude de fluctuation du rayon (R) et afficher une dimension pour cette valeur ($R_{max}$-$R_{min}$) dans un champ d'affichage (8).

2. Dispositif de contrôle selon la revendication 1, **caractérisé en ce que** les valeurs de rayon (R1 à R5) sont calculées à partir des valeurs d'amplitude instantanées de deux signaux de palpage (S1, S2) sinusoïdaux, mutuellement déphasés de 90°, conformément à la formule $R = \sqrt{S1^2 + S2^2}$.

3. Dispositif de contrôle selon la revendication 1, **caractérisé en ce que** la valeur ($R_{max}$-$R_{min}$) de l'amplitude de fluctuation est la différence entre la valeur de rayon maximale ($R_{max}$) et la valeur de rayon minimale ($R_{min}$) d'une série de valeurs de rayons (R1 à R5).

4. Dispositif de contrôle selon une des revendications 1 à 3, **caractérisé en ce que** l'amplitude de fluctuation est indiquée sous la forme d'une barre (9) dans un champ d'affichage (8) du dispositif de contrôle (4) et la largeur de la barre (9) est une dimension pour l'amplitude de fluctuation.

5. Dispositif de contrôle selon la revendication 4, **caractérisé en ce que** la position de la barre (9) dans le champ d'affichage (8) est une dimension pour le rayon moyen de la série de valeurs de rayons (R1 à R5).

6. Dispositif de contrôle selon la revendication 5, **caractérisé en ce qu'**il est prévu dans le champ d'affichage (8), une zone (10) dans laquelle est indiquée une dimension pour la valeur du rayon.

7. Dispositif de contrôle selon une des revendications précédentes, **caractérisé en ce que** le dispositif de contrôle (4) comprend des moyens pour afficher un repère (11.1, 11.2) dans le champ d'affichage (8), indiquant ainsi l'amplitude de fluctuation admissible pour la série de valeurs de rayons (R1 à R5).

8. Dispositif de contrôle selon la revendication 7, **caractérisé en ce que** le repère (11.1, 11,2) se compose d'un repère (11.1) inférieur et d'un second repère (11.2) supérieur et **en ce que** le dispositif de contrôle (4) comprend des moyens pour calculer une valeur de rayon (RM) moyenne à partir de la série de valeurs de rayons (R1 à R5), des moyens pour mémoriser une valeur pour l'amplitude de fluctuation admissible ainsi que des moyens pour calculer les positions des deux repères (11.1, 11.2) à partir de la valeur de rayon moyenne (RM) et de la valeur mémorisée.

9. Dispositif de contrôle selon la revendication 8, **caractérisé en ce que** la valeur mémorisée pour l'amplitude de fluctuation admissible est une grandeur relative rapportée à la valeur de rayon moyenne (RM), de sorte que la distance des deux repères (11.1, 11.2) est indiquée en fonction de la valeur de rayon (RM) moyenne calculée.

10. Dispositif de contrôle selon une des revendications 5 à 9, **caractérisé en ce qu'**il comporte un dispositif de commutation qui, en fonction d'une valeur de rayon ($R_{max}$, $R_{min}$, RM), fait varier la plage de rayons affichée.

11. Dispositif de contrôle selon la revendication 10, **caractérisé en ce que** le dispositif de commutation commande le dispositif de contrôle (4) de telle sorte que celui-ci affiche l'amplitude de fluctuation dans un premier état ou dans un deuxième état dans le champ d'affichage (8), une valeur extrême ($R_{max}$, $R_{min}$) ou la valeur moyenne (RM) de la série de valeurs de rayons (R1 à R5) étant inférieure à une valeur prédéterminée dans le premier état et supérieure à une valeur prédéterminée dans le deuxième état.

12. Dispositif de contrôle selon une des revendications 4 à 11, **caractérisé en ce que** la largeur de la barre (9) pour l'amplitude de fluctuation, au moins dans la zone d'une valeur de consigne de position, est représentée à une échelle plus grande que la position variable de la barre (9) à l'intérieur du champ d'affichage (8).

13. Dispositif de contrôle selon une des revendications 4 à 12, **caractérisé en ce que** la largeur de la barre (9) pour l'amplitude de fluctuation, ainsi que la position variable de la barre (9) à l'intérieur du champ d'affichage (8), dans la zone d'une valeur de consigne de position, sont représentées à une échelle plus grande que dans le reste de la zone.

14. Dispositif de contrôle pour le contrôle de signaux de palpage (S1, S2) mutuellement déphasés d'un dispositif de mesure de position (1, 3), qui sont transmis au dispositif de contrôle (4) aux fins de représenter une grandeur d'une figure de Lissajous correspondant au rayon (R), **caractérisé en ce qu'**il comporte des moyens de commande du dispositif de contrôle (4), pour l'affichage par celui-ci, dans le champ d'affichage (8), en plus de cette grandeur, d'un repère (11.1, 11.2) indiquant une amplitude de fluctuation admissible prédéterminée d'une série de valeurs de rayon (R1 à R5) consécutives.

**15.** Dispositif de contrôle selon une des revendications précédentes, **caractérisé en ce qu'**il comporte des moyens pour produire un signal de commande (S3), qui est transmis à un dispositif de commutation (7) d'une tête de palpage (3.1) du dispositif de mesure de position, aux fins d'obtenir, au niveau des lignes de sortie (5) de la tête de palpage (3.1), des signaux de palpage (S1, S2) analogiques à la place de signaux de palpage numériques (D1, D2).

**16.** Dispositif de contrôle selon une des revendications précédentes, **caractérisé en ce que** le champ d'affichage est un afficheur à cristaux liquides.

**17.** Procédé de contrôle de signaux de palpage (S1, S2) mutuellement déphasés d'un dispositif de mesure de position (1, 3) qui sont transmis à un dispositif de contrôle (4) aux fins de représenter une grandeur d'une figure de Lissajous correspondant au rayon (R), **caractérisé par** les étapes de procédé suivantes :

> a) calcul d'une série de valeurs de rayon (R1 à R5) à partir de valeurs instantanées successives des deux signaux de palpage (S1, S2),
> b) mémorisation des valeurs de rayons (R1 à R5) calculées ;
> c) calcul de l'amplitude de fluctuation partir d'un nombre prédéterminé de valeurs de rayons (R1 à R5) mémorisées,
> d) activation d'un champ d'affichage (8) pour afficher une dimension (9) pour l'amplitude de fluctuation.

FIG. 1

## FIG. 2

## FIG. 3

FIG. 4

FIG. 5

## FIG. 6

## FIG. 7